# FASCICULE DE BREVET EUROPEEN

(11) **EP 1 062 686 B1**
(45) Date de publication et mention de la délivrance du brevet: **24.07.2002**
(21) Numéro de dépôt: 99907668.0
(22) Date de dépôt: 09.03.1999
(51) Int. Cl.: H01L 21/00

(54) **INSTALLATION ET PROCEDE DE TRAITEMENT CHIMIQUE DE PLAQUETTES POUR LA MICRO-ELECTRONIQUE**
VORRICHTUNG UND VERFAHREN ZUM CHEMISCHEN BEHANDLEN VON MIKROELEKTRONISCHEN SCHEIBEN
INSTALLATION AND METHOD FOR CHEMICAL TREATMENT OF MICROELECTRONICS WAFERS

(30) Priorité: 09.03.1998 FR 9802833
(43) Date de publication de la demande: 27.12.2000
(73) Titulaire: S.O.I.Tec Silicon on Insulator Technologies, 38190 Bernin (FR)
(72) Inventeur: LAMURE, Jean-Michel, F-38420 Saint-Jean-le-Vieux (FR)
(74) Mandataire: Le Forestier, Eric
(86) Numéro de dépôt international: FR9900520
(87) Numéro de publication internationale: WO9946802

(56) Documents cités:
- DE-A- 4 300 205
- US-A- 5 657 879

## Description

La présente invention concerne le domaine de la micro-électronique. Plus particulièrement, elle concerne le domaine des installations de traitement de plaquettes de matériau servant de substrats pour la fabrication de composants de micro-électronique et en particulier des installations de traitement chimique.

Plus précisément encore, la présente invention conceme le domaine des installations et des procédés permettant de traiter et manipuler des plaquettes en particulier dans le cadre de procédés de manipulation de plaquettes sans panier, ce type d'installation étant souvent dénommé selon la terminologie anglo-saxonne « cassetteless ». Elle vise toutefois également à certaines manipulations pouvant recourir à des paniers de réception des plaquettes.

On connaît ainsi par le document US 5 657 879 un panier de réception de plaquettes comportant des plaques pour ajuster la capacité de ce panier de réception et des manchons eux aussi en forme de panier pour une adaptation de ce panier de réception à des plaquettes de différentes dimensions.

On connaît également par le document DE 45 00 205 un panier de réception de plaquettes comportant un adaptateur pour recevoir des plaquettes de différentes dimensions.

Le traitement chimique de plaquettes pour la micro-électronique nécessite généralement l'immersion de ces plaquettes dans des bains de produits chimiques, dont certains sont corrosifs.

Dans les installations permettant une manipulation et un traitement de plaquettes sans que celles-ci ne reposent dans des paniers, les plaquettes, qui sont initialement disposées, par exemple, par lots de 25 dans des paniers de manipulation et stockage, sont extraites de ces paniers, pour être immergées successivement dans différents bains chimiques. Entre les bains, les plaquettes sont saisies par des peignes spéciaux, pour être transférées d'un bain chimique à un autre. Dans chaque bain, les plaquettes sont disposées sur des porte-plaquettes destinées à rester en permanence dans le bain chimique.

Les peignes ne restent pas dans les bacs pendant le traitement, les plaquettes étant déposées sur les porte-plaquettes propres à chaque bac. Ce type d'installation permet d'optimiser le traitement chimique en adaptant les porte-plaquettes de chaque bac. Ces porte-plaquettes peuvent être très réduits en volume et en surface pour perturber le moins possible le traitement.

Avec ce type d'installation, on évite la contamination des bains par les produits chimiques, qui restent sur les nacelles ou les paniers lorsque l'on utilise ces nacelles ou ces paniers pour transférer les plaquettes d'un bac à l'autre. En outre, les peignes de transfert peuvent, par exemple, être multiples pour éviter qu'ils ne trempent successivement dans des bains incompatibles chimiquement. Ils peuvent aussi être rincés pendant que les plaquettes subissent un traitement chimique. Cependant, ce type d'installation ne permet pas de traiter plusieurs tailles de plaquettes avec le même système. Le système de peigne est déjà délicat à régler mécaniquement pour garantir une bonne préhension des plaquettes d'un seul type, donc il ne peut être question d'obtenir un réglage susceptible de permettre, de manière satisfaisante, la préhension des plaquettes de plusieurs types, c'est à dire de plusieurs dimensions.

but de l'invention est de fournir un moyen économique permettant un traitement de plusieurs types de plaquettes sur ce type d'installation. Ce but est atteint grâce à une installation de traitement de plaquettes de matériau servant de substrats pour la micro-électronique, telle que définie dans la revendication 1.

Ainsi, grâce à l'installation selon l'invention il est possible, même si celle-ci est dédiée au traitement de plaquettes d'une première dimension, d'effectuer un traitement chimique de plaquettes d'une deuxième dimension plus petite que la première dimension.

Si par exemple, l'installation est dédiée au traitement de plaquettes de 20 cm de diamètre, les moyens de saisie, par exemple des peignes, sont réglés pour ce diamètre, et des bacs sont munis aussi de porte-plaquettes aptes à recevoir des plaquettes de cette dimension.

Néanmoins, l'installation peut aussi servir de traitement de plaquettes de 10 cm, par exemple, puisqu'il suffit de disposer les plaquettes de 10 cm de diamètre dans un support ayant une géométrie telle qu'il peut être saisi par les peignes.

Avantageusement, cette géométrie est déterminée par des plaques de préhension ayant une forme choisie pour que les moyens de préhension puissent les saisir comme s'il s'agissait de plaquettes de la première dimension, c'est à dire des plaques de 20 cm de diamètre, pour l'exemple décrit ci-dessus.

Encore plus avantageusement, le support comporte deux plaques de préhension reliées entre elles par des barreaux aptes à maintenir un lot de plaquettes de la deuxième dimension, soit directement, soit par l'intermédiaire d'un panier.

Selon un autre aspect, l'invention propose un procédé de traitement de plaquettes de matériaux servant de substrats pour la micro-électronique tel que défini dans la revendication 7.

D'autres aspects, buts et avantages de l'invention apparaîtront à la lecture de la description détaillée ci-dessous, donnée à titre d'exemple non limitatif et faite en référence aux dessins annexés, sur lesquels :
- la figure 1 est une représentation schématique en coupe d'une boîte de stockage de plaquettes ;
- la figure 2 représente schématiquement le transfert de plaquettes, d'un panier de stockage et de manipulation vers un support selon l'invention ;
- la figure 3 représente schématiquement en élévation en bout, deux variantes ( figures 3a et 3b) des moyens de manipulation du support selon l'invention ;
- la figure 4 représente schématiquement des éléments de soutien de plaquettes et différents modes de réalisation du chant de moyens de manipulation de supports selon l'invention ; les figures 4a et 4b montrent en coupe, respectivement, des éléments de soutien multiples et simples ; les figures 4c à 4e montrent en coupe différentes formes de chant aptes à coopérer avec les éléments de soutien ; la figure 4f montre un support selon l'invention, vu en élévation en bout, avec un chant du type de celui illustré à la figure 4e, en prise avec des peignes de transfert ;
- la figure 5 est une vue en perspective d'un exemple non limitatif de support selon l'invention ;
- la figure 6 est une vue en perspective d'un autre exemple non limitatif de support selon l'invention ;
- la figure 7 est une représentation schématique et partielle, vue en bout, du support selon l'invention représenté à la figure 6 ; et
- la figure 8 est une représentation schématique de différentes étapes du procédé de traitement de plaquettes, conforme à l'invention.

Les fabricants de composants micro-électroniques utilisent des plaquettes de matériaux tels que du silicium, du quartz, du verre, etc. D'une manière générale, mais sans que ce soit limitatif, ce matériau peut être un matériau semi-conducteur, céramique ou plastique. Les plaquettes sont habituellement rondes et de faible épaisseur. Typiquement, et par exemple pour le silicium, le diamètre de telles plaquettes 1 est de 10 cm (4 pouces), 12,5 cm (5 pouces), 15 cm (6 pouces), 20 cm (8 pouces) ou 30 cm (12 pouces). Mais la présente invention est compatible avec d'autres formes de plaquettes 1. Par exemple, les plaquettes peuvent avoir des formes du type de celles utilisées pour réaliser des écrans plats.

Selon l'invention, ces plaquettes subissent un certain nombre d'étapes de procédés technologiques aboutissant à la réalisation de composants électroniques, optiques ou optoélectroniques. De tels procédés comprennent une ou plusieurs opérations consistant en des traitements chimiques des plaquettes dans des bains chimiques liquides 21.

Ces bains 21 sont typiquement des mélanges à base d'acides, de bases, de solvants ou d'eau dé-ionisée, ainsi que des solutions de rinçage. Ces bains 21 sont contenus dans des bacs 20 alimentés automatiquement en produits chimiques à partir d'une distribution centralisée des produits. Ces bacs 20 peuvent être chauffés et activés par mégasons ou ultrasons. Les bacs 20 sont en général regroupés sur un système de traitements chimiques assurant le transport automatique des plaquettes d'un bac à un autre, depuis une station de chargement et/ou de transfert, jusqu'à une station de déchargement.

Les plaquettes sont avantageusement traitées chimiquement par lots, de 25 par exemple. Avant et après les étapes de traitement chimique, ces lots sont manipulés et stockés dans des premières boîtes de stockage 5.

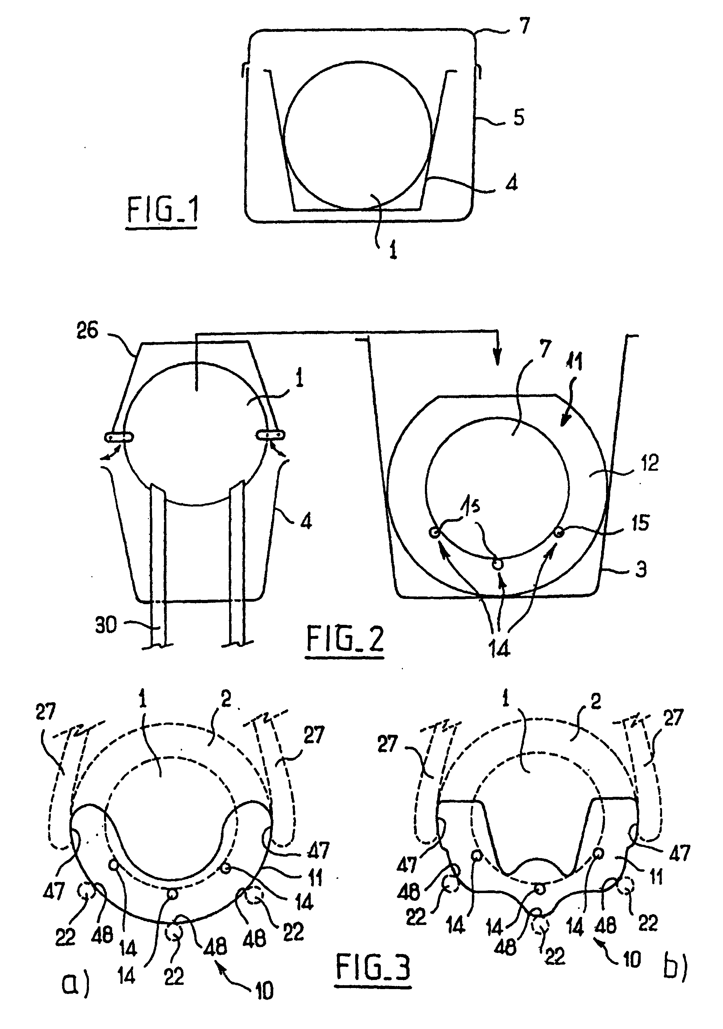

Comme le montre la figure 1, ces premières boîtes de stockage 5 sont fermées par un couvercle 7 et contiennent un panier ou boîte de manipulation et de stockage 4 dans lequel sont rangées les plaquettes. Les paniers de manipulation et de stockage 4 sont constitués d'une matière plastique incompatible avec la nature des bains de traitement chimique généralement utilisés.

Selon un exemple particulier de mode de mise en oeuvre du procédé selon l'invention, on utilise une installation dédiée à des plaquettes de 20 cm de diamètre pour le traitement chimique de plaquettes de 10 cm de diamètre, à l'aide d'un support 10 tel qu'on va le décrire plus loin.

Dans la description détaillée qui suit, on désigne par la référence 1 les plaquettes de 10 cm de diamètre, et par la référence 2 les plaquettes de 20 cm de diamètre.

Comme illustré à la figure 2, un système de transfert 30 permet de sortir les plaquettes 1 de 10 cm de diamètre hors du panier de manipulation et stockage 4. Puis, des moyens de transfert 26, viennent en prise avec les plaquettes 1 de 10 cm de diamètre et les déplacent pour les déposer dans un support 10. Le support 10 peut alors être déposé dans un deuxième panier de manipulation et de stockage 3, qui peut lui même être rangé dans une autre boîte en attendant, par exemple, un traitement chimique des plaquettes 1.

Avantageusement, ce deuxième panier de manipulation et stockage 3 est identique à ceux adaptés pour recevoir des plaquettes 2 de 20 cm de diamètre.

D'une manière générale, le support 10 doit être compatible avec les traitements physico-chimiques mentionnés ci-dessus et ne doit pas contaminer les plaquettes 1. Avantageusement, le support 10 est en matériau très pur et inerte chimiquement comme le quartz ou différents plastiques et produits fluorés. Un tel support 10 comprend des éléments de préhension 11 et des éléments de maintien 14 des plaquettes 1 sur le support 10. Par exemple, et de manière non limitative, les éléments de préhension 11 sont constitués d'une paire de plaques de préhension 12 et les éléments de maintien 14 sont constitués de barreaux 15.

Conformément à la présente invention, le support 10 est destiné à permettre une utilisation des équipements adaptés à la manipulation de plaquettes 2 de 20 cm de diamètre, pour traiter des plaquettes 1 de 10 cm de diamètre. Les éléments de préhension 11 doivent donc avoir une forme compatible avec ces équipements, puisque c'est par les éléments de préhension 11 que sont manipulés les supports 10. Ainsi, lorsque par exemple, deux peignes de transfert 27 sont adaptés pour venir en prise avec deux zones, diamétralement opposées, des plaquettes 2 de 20 cm de diamètre, il faut pour que les peignes de transfert 27 puissent aussi venir en prise avec les éléments de préhension 11, que ces derniers possèdent aussi deux zones de préhension 47 diamétralement opposées, écartées d'une distance approximativement égale à 20 cm (figures 3a et 3b). De même, pour que le support 10 puisse être déposé au fond des bacs 20, sur des porte-plaquettes 22, conçus pour recevoir des plaquettes 2 de 20 cm de diamètre, il faut que les éléments de préhension 11 possèdent des zones d'appui 48 permettant de faire reposer le support 10 sur les porte-plaquettes 22 (figures 3a et 3b).

Dans une forme de réalisation de base, les éléments de préhension 11 ont des dimensions (diamètre et épaisseur) identiques à celles de plaquettes 2, de telle sorte qu'ils peuvent d'une part être saisis par les peignes de transfert 27 conçus à l'origine pour saisir de telles plaquettes 2, et d'autre part être calés dans des boîtes de stockage conçus à l'origine pour recevoir de telles plaquettes 2.

Toutefois, la forme des éléments de préhension 11 peut être différente, et optimisée pour que les traitements chimiques soient efficaces et homogènes, tout en respectant la disposition et la géométrie des zones de préhension 47, des zones d'appui 48 et des éléments de maintien 14. Les figures 3a et 3b illustrent deux exemples de réalisation de tels éléments de préhension 11. Sur ces figures est également illustrée, en tiretés, la position qu'adopterait une plaquette à traiter plus grande 2 dans les peignes de transfert 27.

Avantageusement aussi, les éléments de préhension 11, lorsqu'ils présente une épaisseur supérieure à l'épaisseur des plaquettes 2, possèdent, au moins au niveau des zones de préhension 47 et des zones d'appui 48, un chant 43 propre à coopérer avec les paniers de stockage et manipulation 3, avec les moyens de transfert 26 avec les peignes de transfert 27 et avec les porte-plaquettes 22.

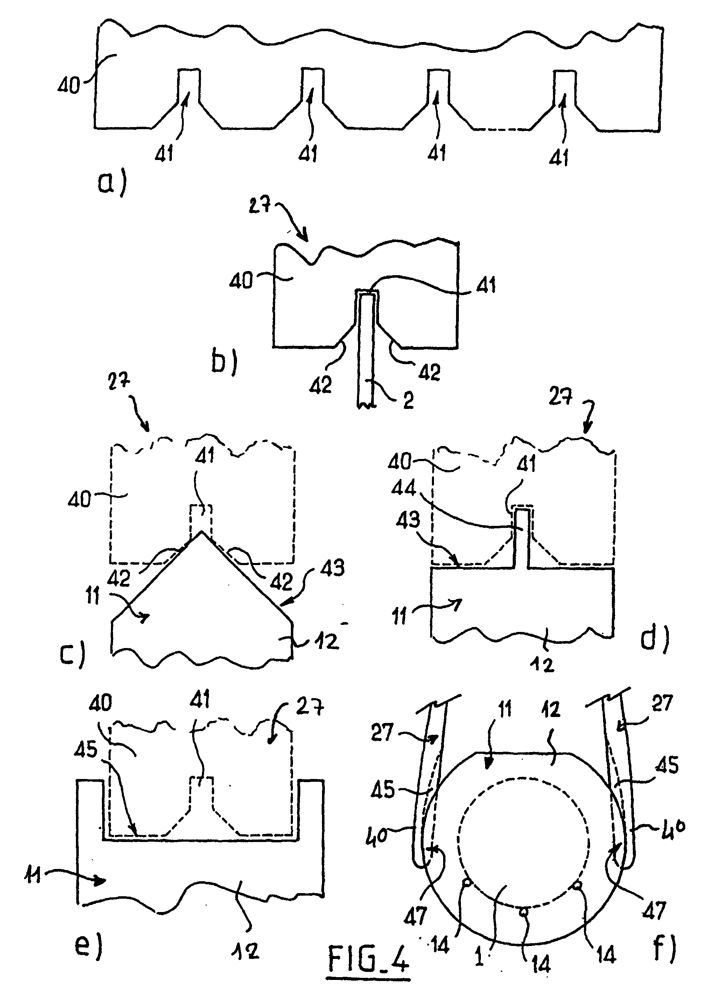

En effet, les paniers de stockage et manipulation 3, les moyens de transfert 26, les peignes de transfert 27 ou les éléments porte-plaquettes 22 comportent généralement des parties de saisie 40 munies d'encoches 41. Il peut y avoir une série d'encoches 41 sur chaque partie de saisie 40 (figure 4a) ou une seule encoche 41 par partie de saisie 40 (figure 4b).

Comme l'illustre en particulier la figure 4b, une encoche 41 a un profil adapté pour caler une plaquette 1. Des chanfreins 42 sont prévus de part et d'autre de chaque encoche 41 pour guider les plaquettes 1, vers l'encoche 41. Dans le cas où les éléments de préhension 11 ont une épaisseur plus importante que celle d'une plaquette 2, ils ne peuvent pas pénétrer directement dans les encoches 41 des peignes de transfert 27. Le chant 43 des éléments de préhension 11 est alors conformé de manière à coopérer de manière étroite et sûre avec les parties de saisie 40. Ainsi, le chant 43 peut aussi être chanfreiné pour coopérer avec les chanfreins 42 des parties de saisie 40 (figure 4c). Le chant 43 peut aussi, selon une variante, être plat et comprendre un élément faisant saillie 44 (figure 4d). Cet élément faisant saillie 44 a alors une épaisseur égale à celle d'une plaquette 1. Le chant 43 des éléments de préhension 11 peut aussi, selon une autre variante, comprendre une rainure 45 dans laquelle peut pénétrer l'ensemble de la partie de saisie 40 (figure 4e). La figure 4f montre une plaque de préhension 12 qui, conformément à cette dernière variante, est en prise avec des peignes de transfert 27. Les bords de la rainure 45 viennent recouvrir les peignes de transfert 27, localement, au niveau de la zone de préhension 47 de la plaque de préhension 12 par ces peignes de transfert 27.

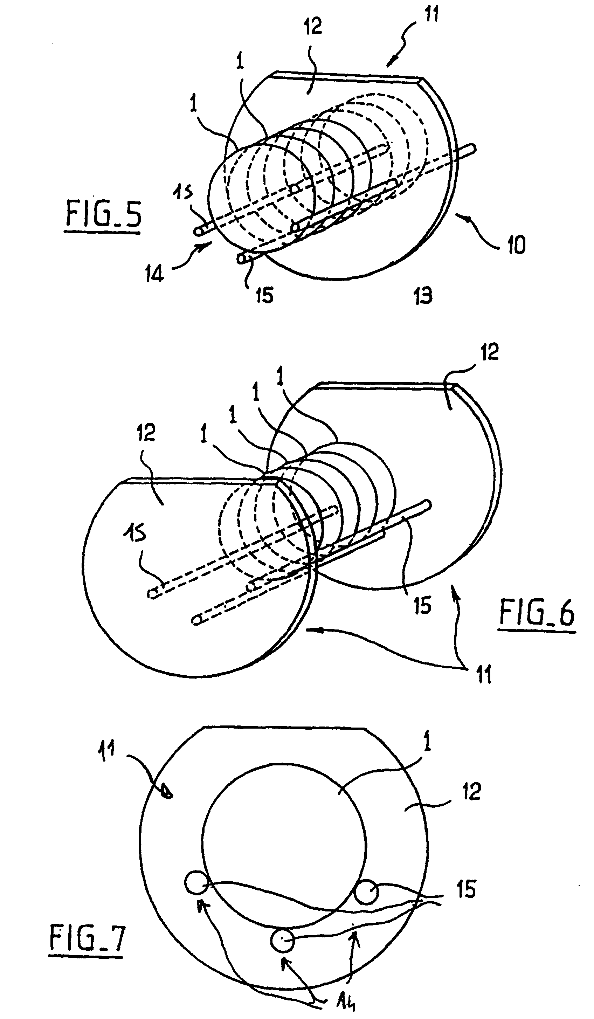

Selon un mode de réalisation particulier mais non limitatif du support 10 représenté à la figure 5, celui-ci comprend une plaque de préhension verticale unique 12 et trois barreaux horizontaux 15. La plaque de préhension 12 est placée au milieu des barreaux 15, perpendiculairement à ceux-ci. Les barreaux 15 sont rigidement liés à la plaque de préhension 12. Les plaquettes 1 de 10 cm de diamètre sont alors disposées parallèlement à la plaque de préhension 12 sur les trois barreaux 15, de part et d'autre de la plaque de préhension 12. Les trois barreaux 15 présentent des encoches 41 régulièrement réparties sur leur longueur.

Le mode préféré de réalisation du support 10, tel que décrit schématiquement plus haut, est quant à lui illustré plus clairement sur les figures 6 et 7, où l'on observe les deux plaques de préhension verticales 12 et les trois barreaux de maintien horizontaux 15, formant un ensemble rigide. Les plaquettes du premier type 1 sont disposées sur les barreaux 15, entre les deux plaques de préhension 12, parallèlement à celles-ci.

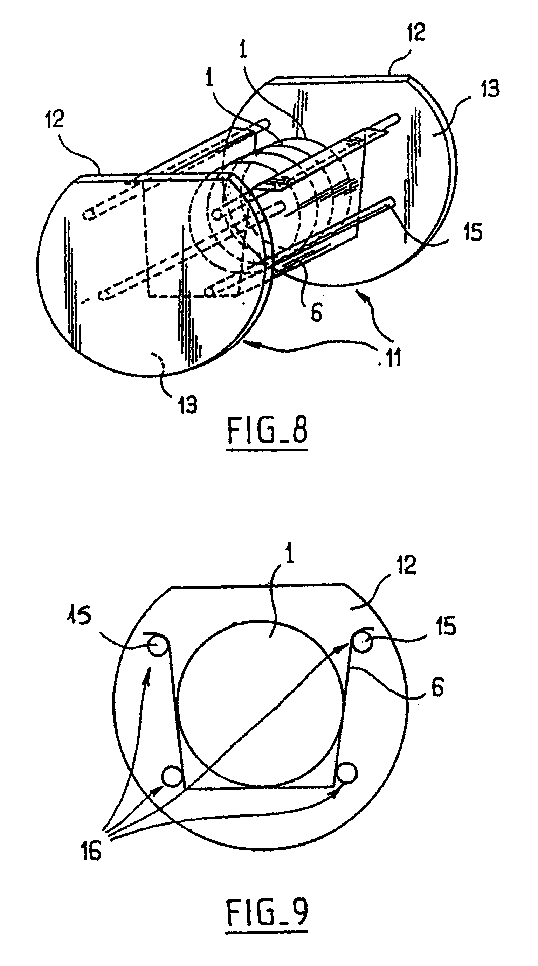

Selon un autre mode de réalisation du support 10, tel qu'illustré sur les figures 8 et 9, celui-ci comprend deux plaques de préhension 12 et quatre barreaux 15. Chaque extrémité d'un barreau 15 est située, sur la face interne 13 d'une plaque de préhension 12, à l'un des quatre sommets d'un trapèze. Ainsi disposés, les barreaux 15 constituent un élément porte-panier 16. Cet élément porte-panier 16 est destiné à recevoir et maintenir un panier 6 regroupant en vue de leur traitement une série de plaquettes 1.

Il a été décrit ci-dessus des supports 10 comprenant une ou deux plaques de préhension 12 et trois ou quatre barreaux 15. On comprendra que d'autres variantes du support 10 peuvent comprendre plus de deux plaques de préhension 12 ou un nombre différent de barreaux 15, ou encore d'autres types d'éléments d'appui 14, 15 pour les plaquettes 1, par exemple des surfaces concaves continues ou discontinues.

On va maintenant donner deux exemples de procédés selon la présente invention, mettant en oeuvre des supports 10 tels que décrits ci-dessus.

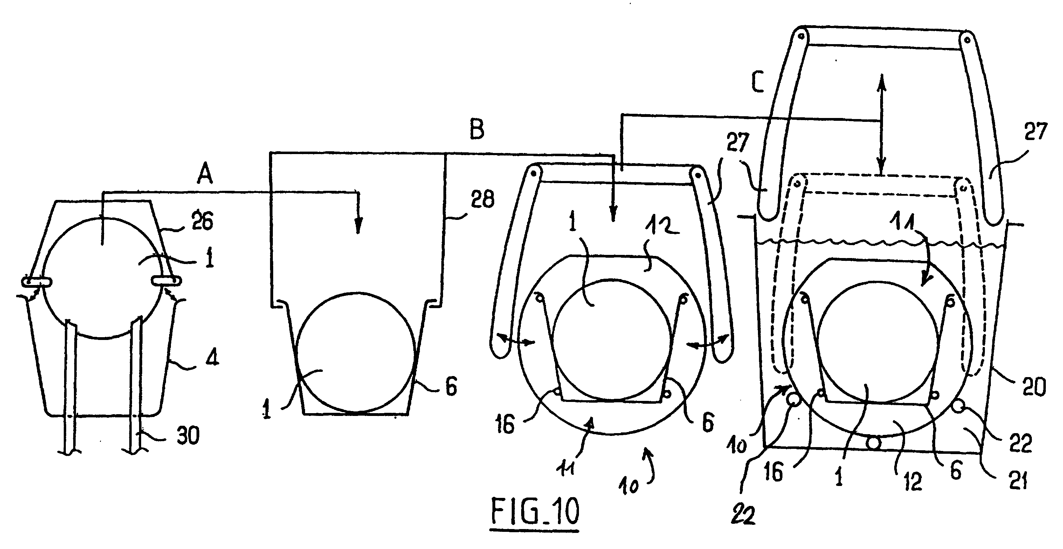

Le premier de ces exemples est illustré schématiquement sur la figure 10 et met en oeuvre un support tel que décrit en référence aux figures 8 et 9. Les plaquettes du premier type 1 sont sorties au cours d'une étape A des paniers de manipulation et stockage 4 grâce à des moyens de transfert 26, 30 connus en eux-mêmes. Les plaquettes du premier type 1 sont soulevées par les moyens 30 et saisies par les moyens 26 pour être déposées dans un panier de traitement 6 (étape A). Un dispositif 28 de transfert de panier vient en prise avec le panier de traitement 6 pour le déplacer et le déposer dans un support 10 conforme aux figures 8 et 9 (étape B). Des peignes de transfert 27, conçus à l'origine pour saisir et déplacer des plaquettes plus grandes 2, peuvent alors, au cours d'une étape C, venir en prise avec les plaques de préhension 12 pour déplacer le support 10 muni du panier 6 contenant les plaquettes 1 vers un bac 20. Le bac 20 contient un bain de traitement chimique 21. Le support 10 est disposé au fond du bac 20 en prenant appui par l'intermédiaire de ses plaques de préhension 12 sur des tiges porte-plaquettes 22 conçues à l'origine pour recevoir des plaquettes plus grandes 2. Avantageusement, les peignes de transfert 27 sont retirés du bac 20 pendant le traitement chimique, et peuvent alors éventuellement subir une opération de rinçage. Après la fin du traitement chimique, les peignes de transfert 27 viennent saisir, soulever et déplacer le support 10. Le support 10 est éventuellement déplacé vers un nouveau bac de traitement chimique. A la fin des opérations de traitement chimique, les étapes A, B, C décrites ci-dessus peuvent être reproduites dans le sens chronologique inverse, avant de procéder au déchargement et/ou au stockage des plaquettes du premier type 1.

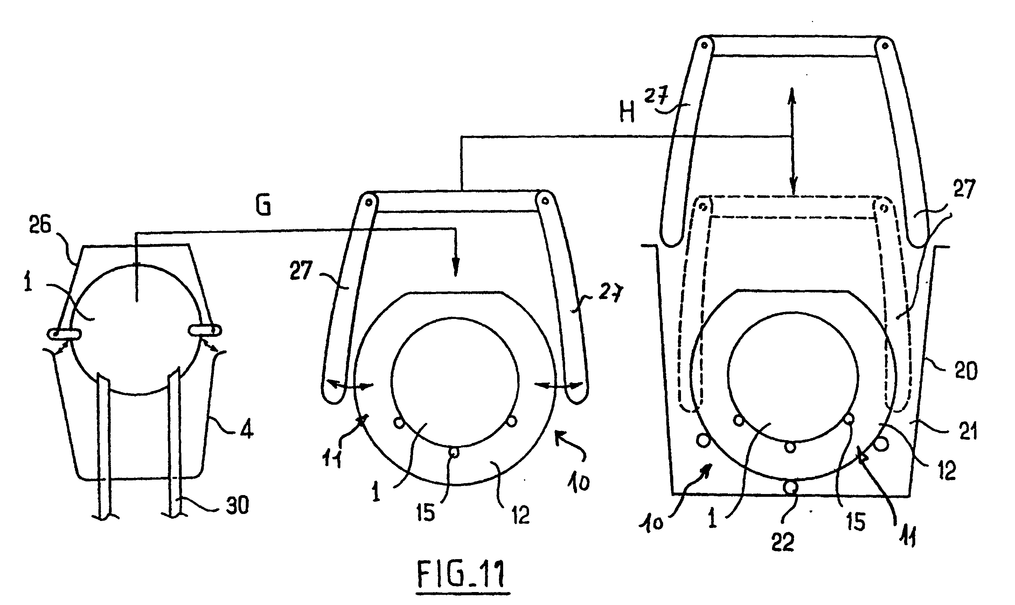

Un deuxième exemple d'un procédé conforme à la présente invention est décrit ci-dessous en référence à la figure 11. Il comprend deux étapes principales G et H. Au cours de l'étape G, les plaquettes 1 de 10 cm de diamètre sont transférées d'un panier de manipulation et stockage 4 vers un support 10, à l'aide des moyens de transfert 26, 30. Des peignes de transfert 27, ici encore conçus à l'origine pour saisir et déplacer des plaquettes plus grandes 2, viennent alors en prise avec les plaques de préhension 12 pour soulever et déplacer le support 10 vers un bac 20 au fond duquel le support 10 est déposé sur des tiges porte-plaquettes 22, conçues ici encore à l'origine pour recevoir des plaquettes plus grandes 2 (étape H). Le bac 20 contient un bain de traitement chimique. Préférentiellement, les peignes de transfert 27 sont retirés du bac 20 pour être rincés pendant que se déroule le traitement des plaquettes 1. Ensuite, soit les opérations G et H sont réalisées en sens inverse pour ranger les plaquettes 1 de 10 cm de diamètre dans des boîtes de stockage et manipulation 4, soit le support 10 est déplacé dans un nouveau bac pour subir un autre traitement chimique ou un rinçage.

Pour illustrer la mise en oeuvre de l'invention, il a été pris comme exemple celui de plaquettes 1 de 10 cm, traitées sur une installation dédiée initialement au traitement de plaquettes 1 de 20 cm de diamètre, mais l'invention peut évidemment être mis en oeuvre avec deux autres quelconques dimensions de plaquettes 1.

Il ressort de ce qui précède qu'une installation et un procédé de traitement selon l'invention permettent d'utiliser plusieurs types de plaquettes 1 différant par leur dimension, sans avoir à changer ou à régler différemment, les peignes de transfert 27, les bacs 20 munis de leurs tiges porte-plaquettes 22, etc.

## Revendications

1. Installation de traitement de plaquettes (1) de matériau servant de substrats pour la micro-électronique, comprenant :
- un bac (20) destiné à contenir un bain (21) de traitement et muni de moyens porte-plaquettes (22) apte à recevoir au moins une plaquette (2) ayant une première dimension transversalement à son épaisseur ; et
- des moyens de préhension (27) aptes à saisir chaque plaquette de ayant la première dimension, pour la mettre dans le bac et la sortir de celui-ci ;
**caractérisée en ce qu'**elle comporte en outre un support (10) apte à recevoir au moins une plaquette (1) ayant une deuxième dimension, transversalement à son épaisseur, plus petite que la première dimension, ce support présentant une géométrie telle qu'il peut être saisi directement par les moyens de préhension (27) et être reçu par les moyens porte-plaquettes (22) du bac (20).

2. Installation selon la revendication 1, **caractérisée en ce que** le support (10) comporté au moins une plaque de préhension (12) ayant une forme choisie pour que les moyens de préhension puissent la saisir comme s'il s'agissait d'une plaquette (2) de la première dimension.

3. Installation selon la revendication 2, **caractérisée en ce que** le support comporte deux plaques de préhension (12) ayant chacune une forme choisie pour que les moyens de préhension puissent la saisir comme s'il s'agissait d'une plaquette (2) de la première dimension et reliées entre elles par des moyens supports (15) aptes à maintenir un lot de plaquettes (1) de la deuxième dimension.

4. Installation selon la revendication 3, **caractérisée en ce que** les moyens supports comprennent une pluralité de barreaux (15).

5. Installation selon l'une des revendications 3 et 4, **caractérisée en ce que** les moyens supports (15) sont aptes à recevoir directement lesdites plaquettes (1) de la deuxième dimension.

6. Installation selon l'une des revendications 3 et 4, **caractérisée en ce que** les moyens supports (15) sont aptes à recevoir lesdites plaquettes (1) de la deuxième dimension par l'intermédiaire d'un panier (6) dans lequel sont logées lesdites plaquettes (1).

7. Procédé de traitement de plaquettes (1) de matériaux servant de substrats pour la micro-électronique, comprenant une étape de mise en oeuvre de moyens de préhension (27) conçus à l'origine pour saisir au moins une plaquette (2) d'une première dimension transversalement à son épaisseur et à immerger chaque plaquette (2) dans un bain de traitement (21) contenu dans un bac (20) muni de moyens porte-plaquettes (22) aptes à recevoir au moins une plaquette (2) de ladite première dimension, **caractérisé par le fait qu'**il comporte alternativement une étape de mise en oeuvre des mêmes moyens de préhension (27) pour saisir un support (10) apte à recevoir au moins une plaquette (1) d'une deuxième dimension, transversalement à son épaisseur, plus petite que la première dimension, et immerger ces plaquettes (1) de la deuxième dimension dans le bain de traitement (21) en déposant ledit support (10) dans ledit bac (20) pour qu'il soit reçu par lesdits moyens porte-plaquettes (22).

8. Procédé selon la revendication 7, **caractérisé en ce que** ladite étape alternative est précédée d'une étape de placement desdites plaquettes (1) de la deuxième dimension directement dans le support (10).

9. Procédé selon la revendication 7, **caractérisé en ce que** ladite étape alternative est précédée d'une étape de placement desdites plaquettes (1) de la deuxième dimension dans un panier (6) et d'une étape de placement dudit panier (6) dans le support (10).

## Claims

1. An installation for treating wafers (1) of a material used as a substrates for microelectronics, the installation comprising:
- a tank (20) adapted to contain a treatment bath (21) and provided with wafer support means (22) adapted to receive at least one wafer (2) of a first size transverse to its thickness; and
- holding means (27) adapted to grasp each first size wafer to place it in the tank and withdraw it therefrom;
**characterized in that** it further includes a support (10) adapted to receive at least one wafer (1) of a second size transverse to its thickness less than the first size, which support has a geometry such that it can be grasped directly by the holding means (27) and received by the wafer support means (22) of the tank (20).

2. An installation according to claim 1, **characterized in that** the support (10) includes at least one holding plate (12) having a shape chosen so that the holding means can grasp it as if it were a first size wafer (2).

3. An installation according to claim 2, **characterized in that** the support includes two holding plates (12) each having a shape chosen so that the holding means can grasp it as if it were a first size wafer (2) and the two plates are joined together by support means (15) adapted to retain a batch of second size wafers (1).

4. An installation according to claim 3, **characterized in that** the support means comprise a plurality of bars (15).

5. An installation according to either claim 3 or claim 4, **characterized in that** the support means (15) are adapted to receive said second size wafers (1) directly.

6. An installation according to either claim 3 or claim 4, **characterized in that** the support means (15) are adapted to receive said second size wafers (1) through the intermediary of a cassette (6) in which said wafers (1) are housed.

7. A method of treating wafers (1) of materials used as substrates for microelectronics, including a step of employing holding means (27) originally designed to grasp at least one wafer (2) of a first size transverse to its thickness and to immerse each wafer (2) in a treatment bath (21) contained in a tank (20) provided with wafer support means (22) adapted to receive at least one wafer (2) of said first size, **characterized in that** it alternatively includes a step of using the same holding means (27) to grasp a support (10) adapted to receive at least one wafer (1) of a second size, transverse to its thickness less than the first size, and to immerse these second size wafers (1) in the treatment bath (21) by depositing said support (10) in said tank (20) so that it is received by said wafer support means (22).

8. A method according to claim 7, **characterized in that** said alternative step is preceded by a step of placing said second size wafers (1) directly in the support (10).

9. A method according to claim 7, **characterized in that** said alternative step is preceded by a step of placing said second size wafers (1) in a cassette (6) and a step of placing said cassette (6) in the support (10).

## Patentansprüche

1. Einrichtung zur Behandlung von Plättchen (1) aus Material, um als Substräte für die Mikroelektronik zu dienen, mit:
- einem Behälter (20), der dazu bestimmt ist, ein Behandlungsbad (21) zu enthalten, und der mit Plättchenträgermitteln (22) ausgestattet ist, die dazu eingerichtet sind, mindestens ein Plättchen (2) mit einer ersten Abmessung quer zu seiner Dicke aufzunehmen; und
- Greifmitteln (27), die dazu eingerichtet sind, jedes Plättchen mit der ersten Abmessung zu ergreifen, um es in den Behälter zu geben und aus diesem herauszuheben;
**dadurch gekennzeichnet, daß** sie außerdem einen Träger (10) aufweist, der dazu eingerichtet ist, mindestens ein Plättchen (1) mit einer zweiten Abmessung quer zu seiner Dicke aufzunehmen, die kleiner ist als die erste Abmessung, wobei dieser Träger eine solche Geometrie aufweist, daß er unmittelbar durch die Greifmittel (27) ergriffen werden kann und von den Plättchenträgern (22) des Behälters (20) aufgenommen werden kann.

2. Einrichtung nach Anspruch 1, **dadurch gekennzeichnet, daß** der Träger (10) mindestens eine Greifplatte (12) aufweist, die eine Form aufweist, die so ausgewählt ist, daß die Greifmittel sie ergreifen können, wenn es sich um ein Plättchen (2) der ersten Abmessung handelt.

3. Einrichtung nach Anspruch 2, **dadurch gekennzeichnet, daß** der Träger zwei Greifplatten (12) aufweist, die jeweils eine Form aufweisen, die so ausgewählt ist, daß die Greifmittel sie ergreifen können, wenn es sich um ein Plättchen (2) der ersten Abmessung handelt, und die untereinander durch Trägermittel (15) verbunden sind, die dazu eingerichtet sind, eine Charge von Plättchen (1) der zweiten Abmessung zu halten.

4. Einrichtung nach Anspruch 3, **dadurch gekennzeichnet, daß** die Trägermittel eine Vielzahl von Stäben (15) aufweisen.

5. Einrichtung nach einem der Ansprüche 3 und 4, **dadurch gekennzeichnet, daß** die Trägermittel (15) dazu eingerichtet sind, die genannten Plättchen (1) der zweiten Abmessung unmittelbar aufzunehmen.

6. Einrichtung nach einem der Ansprüche 3 und 4, **dadurch gekennzeichnet, daß** die Trägermittel (15) dazu eingerichtet sind, die genannten Plättchen (1) der zweiten Abmessung mittels einer Kassette bzw. eines Korbes (6) aufzunehmen, in dem die genannten Plättchen (1) sitzen.

7. Verfahren zur Behandlung von Plättchen (1) aus Material, um als Substrat für die Mikroelektronik zu dienen, mit einem Schritt des Einsetzens von Greifmitteln (27), die ursprünglich dazu konzipiert sind, mindestens ein Plättchen (2) einer ersten Abmessung quer zu seiner Dicke zu ergreifen und um jedes Plättchen (2) in ein Behandlungsbad (21) einzutauchen, das in einem Behälter (20) enthalten ist, der mit Plättchenträgermitteln (22) versehen ist, die dazu eingerichtet sind, mindestens ein Plättchen (2) der genannten, ersten Abmessung aufzunehmen, **dadurch gekennzeichnet, daß** es alternativ einen Schritt des Einsetzens derselben Greifmittel (27) aufweist, um einen Träger (10) zu ergreifen, der dazu eingerichtet ist, mindestens ein Plättchen (1) einer zweiten Abmessung quer zu seiner Dicke aufzunehmen, die kleiner ist als die erste Abmessung, und dieses Plättchen (1) der zweiten Abmessung in das Behandlungsbad (21) einzutauchen, indem man den genannten Träger (10) im genannten Behälter (20) absetzt, damit er durch die genannten Plättchenträgermittel (22) aufgenommen wird.

8. Verfahren nach Anspruch 7, **dadurch gekennzeichnet, daß** dem genannten, alternativen Schritt ein Schritt des Einsetzens der genannten Plättchen (1) mit der zweiten Abmessung unmittelbar in den Träger (10) vorausgeht.

9. Verfahren nach Anspruch 7, **dadurch gekennzeichnet, daß** dem genannten, alternativen Schritt ein Schritt des Einsetzens der genannten Plättchen (1) mit der zweiten Abmessung in eine Kassette bzw. in einen Korb (6) und ein Schritt des Einsetzens der bzw. des genannten Kassette bzw. Korbes (6) in den genannten Träger (10) vorausgeht.
